# EUROPÄISCHE PATENTANMELDUNG

(11) **EP 4 800 403 A2**
(43) Veröffentlichungstag der Anmeldung: **02.09.2026**
(21) Anmeldenummer: 26185559.7
(22) Anmeldetag: 04.07.2019
(51) Int. Cl.: G01R 23/16

(54) **VERFAHREN ZUM ERKENNEN NIEDERFREQUENTER SCHWINGUNGEN UND ERFASSUNGSEINRICHTUNG DAFÜR**

(30) Priorität: 06.07.2018 DE 102018116445
(62) Dokumentnummer(n) der früheren Anmeldung(en) nach Art. 76 EPÜ: 19736686.7 / 3 818 613
(71) Anmelder: Wobben Properties GmbH, 26607 Aurich (DE)
(72) Erfinder: Schwanka Trevisan, Aramis, 26605 Aurich (DE)
(74) Vertreter: Eisenführ Speiser

(57) **Zusammenfassung**

Die Erfindung betrifft ein Verfahren zum Erkennen niederfrequenter Schwingungen, insbesondere subsynchroner Resonanzen in einem elektrischen Versorgungsnetz (306), wobei das elektrische Versorgungsnetz (306) eine Netzspannung mit einer Netznennfrequenz aufweist, umfassend die Schritte Erfassen wenigstens eines elektrischen Signals des elektrischen Versorgungsnetzes (306) und Auswerten des elektrischen Signals mittels einer Wavelet-Analyse, bei der über eine Korrelationsanalyse des erfassten Signals mit einer vorbestimmten Wavelet-Mutterfunktion (502) ein zeitabhängiges Frequenzbild (420) erstellt wird, wobei vom Vorliegen einer niederfrequenten Schwingung ausgegangen wird, wenn in dem zeitabhängigen Frequenzbild (420) zusätzlich zu einem Grundanteil wenigstens ein weiterer niederfrequenter Frequenzanteil vorhanden ist, wobei das Verfahren an einem Netzanschlusspunkt vorgenommen wird, an dem wenigstens eine dezentrale Erzeugungseinheit, insbesondere eine Windenergieanlage (100, 301) oder ein Windpark (112), in das elektrische Versorgungsnetz (306) einspeist, wobei zur Erkennung der niederfrequenten Schwingungen wenigstens eine elektrische Größe der Einspeisung aufgenommen und mittels der Wavelet-Analyse ausgewertet wird.

## Beschreibung

Die vorliegende Erfindung betrifft ein Verfahren zum Erkennen niederfrequenter Schwingungen in einem elektrischen Versorgungsnetz. Die vorliegende Erfindung betrifft auch eine Erkennungseinrichtung zum Erkennen niederfrequenter Schwingungen in einem elektrischen Versorgungsnetz und die Erfindung betrifft eine Windenergieanlage oder einen Windpark mit einer solchen Erkennungseinrichtung.

Windenergieanlagen und Windparks mit mehreren Windenergieanlagen speisen heutzutage nicht mehr oder immer seltener im sogenannten Netzparallelbetrieb in das elektrische Versorgungsnetz ein, sondern beteiligen sich auch zunehmend an einer Netzstützung und Netzstabilisierung. Ein solches elektrisches Versorgungsnetz, oder ein Teil davon, kann auch als Energiesystem bezeichnet werden. Solche Energiesysteme umfassen dabei elektrische Energieerzeuger, elektrische Verbraucher und elektrische Leitungen, die die elektrischen Erzeuger und Verbraucher direkt oder indirekt verbinden, um darüber elektrische Leistung zwischen den Erzeugern und Verbrauchern zu übertragen. Solche Energiesysteme sind meist schwingungsfähige Systeme, die natürliche Moden unterhalb und oberhalb einer Systemfrequenz, insbesondere einer Netznennfrequenz besitzen. Eine solche Netznennfrequenz ist üblicherweise eine Frequenz von 50 Hz oder 60 Hz. Wenn solche Moden bzw. Schwingungen angeregt werden, können solche Schwingungen die Systemstabilität beeinträchtigen, wenn sie nicht ausreichend gedämpft sind.

Windenergieanlagen können zur Stabilisierung eines solchen Energiesystems beitragen. Dabei ist zu beachten, dass die Lebensdauer einer Windenergieanlage, die vereinfachend auch als Windturbine bezeichnet werden kann, regelmäßig für viele Jahre ausgelegt ist. Üblicherweise kann eine solche Lebensdauer beispielsweise für 25 Jahre ausgelegt sein. Dazu ist zu beachten, dass sich in dieser Zeit das Energiesystem stark ändern und entwickeln kann.

Wenn schwach gedämpfte Netzschwingungsmoden vor einem Windparkanschluss identifiziert werden, sei es durch eine direkte Information vom relevanten Netzbetreiber oder auf Basis von Simulationsstudien, können möglicherweise diese Netzschwingungsmoden noch bei der Auslegung von Windturbinen- und Windparkreglern berücksichtigt werden.

Allerdings kann sich während des Betriebs eines Windparks bzw. einer Windenergieanlage ein solches Energiesystem noch maßgebend entwickeln, also verändern. Ein anfangs auf das Energiesystem ausgelegter Regler einer Windenergieanlage oder eines Windparks wäre dann möglicherweise nicht mehr ausreichend an das Energiesystem angepasst, nachdem es sich verändert hat.

Um diesem Problem zu begegnen, wäre beispielsweise wünschenswert, die Systemcharakteristik eines solchen Energiesystems zu beobachten. Eine solche Beobachtung kann aber kompliziert und aufwändig sein. Außerdem stellt sich die Frage, wie eine solche Beobachtung der Systemcharakteristik ausgewertet werden soll.

Zusätzlich zu dem Problem, eine solche Beobachtung systemtechnisch weiterverarbeiten zu können, kann auch das Problem auftreten, dass spezielle Charakteristika, wie niederfrequente Schwingungen, nur kurzzeitig auftreten. Das kann besonders dazu führen, dass eine solche niederfrequente Schwingung schwer zu erfassen ist. Besonders ist es bereits schwierig, eine Frequenz zu erfassen, die nur zeitweise auftritt. Aber selbst wenn eine solche Frequenz erfasst werden kann, stellt sich auch noch die Schwierigkeit, zu erkennen, dass es eine niederfrequente Schwingung ist. Stellt sich nämlich eine niederfrequente Schwingung nur kurzfristig ein, kann sie auch für ein transientes Ergebnis oder einen transienten Vorgang gehalten werden. Neben der physikalischen Erkennung ist also auch die Interpretation einer solchen flüchtigen Schwingung problematisch.

Der vorliegenden Erfindung liegt somit die Aufgabe zugrunde, zumindest eines der oben genannten Probleme zu adressieren. Insbesondere soll eine niederfrequente Schwingung in einem elektrischen Versorgungsnetz erkannt werden, insbesondere selbst dann, wenn sie nicht dauerhaft auftritt. Zumindest soll zu bisher bekannten Lösungen eine alternative Lösung vorgeschlagen werden.

Erfindungsgemäß wird ein Verfahren gemäß Anspruch 1 vorgeschlagen. Ein solches Verfahren ist ein Verfahren zum Erkennen niederfrequenter Schwingungen, insbesondere subsynchroner Resonanzen in einem elektrischen Versorgungsnetz. Subsynchrone Resonanzen, also Resonanzen mit einer Frequenz unterhalb der Netznennfrequenz, bilden somit niederfrequente Schwingungen aus. Subsynchrone Resonanzen sind insoweit eine Möglichkeit niederfrequenter Schwingungen, wobei niederfrequente Schwingungen aber beispielsweise auch auftreten können, ohne dass ihnen eine Resonanz zugrunde liegt bzw. eine Resonanz die Ursache ist.

Es wird somit bei dieser Betrachtung von einem elektrischen Versorgungsnetz ausgegangen, das eine Netzspannung mit einer Netznennfrequenz aufweist. Die zu erkennende niederfrequente Schwingung weist eine Frequenz auf, die vorzugsweise geringer ist als die Netznennfrequenz.

Besonders können die niederfrequenten Schwingungen Werte von 1 Hz und weniger aufweisen. Sie können aber auch bis zum fünffachen Wert der Netznennfrequenz reichen. Als niederfrequente Schwingungen werden hier Schwingungen mit einer Frequenz von maximal dem fünffachen Wert der Netznennfrequenz bezeichnet, vorzugsweise mit einer Frequenz die maximal der Netznennfrequenz entspricht. Besonders weist die niederfrequente Schwingung keine Frequenz auf, die einem Vielfachen der Netznennfrequenz entspricht. Es ist zu beachten, dass die Untersuchung und Berücksichtigung niederfrequenter Schwingungen besonders der Untersuchung oder dem Sicherstellen einer Systemstabilität des elektrischen Versorgungsnetzes dient. Das grenzt sich von einer Beurteilung der Netzqualität bzw. Signalqualität des Spannungssignals im elektrischen Versorgungsnetz ab, bei der es besonders auf Oberwellen ankommt.

Das Verfahren umfasst nun zunächst den Schritt, wenigstens ein elektrisches Signal des elektrischen Versorgungsnetzes zu erfassen. Besonders wird hier eine Spannungsmessung beispielsweise am Netzanschlusspunkt vorgeschlagen, an dem eine Windenergieanlage oder ein Windpark in das elektrische Versorgungsnetz einspeist. Vorzugsweise wird hier eine dreiphasige Messung vorgenommen, wenn das elektrische Versorgungsnetz - wovon üblicherweise auszugehen ist - ein dreiphasiges elektrisches Versorgungsnetz ist.

Das Auswerten des elektrischen Signals erfolgt dann mittels einer Wavelet-Analyse. Eine Wavelet-Analyse ist dem Grunde nach bekannt und insoweit wird auf entsprechende Fachliteratur bzw. das Fachwissen des Fachmanns dazu verwiesen. Hier wird nun aber vorgeschlagen, diese Wavelet-Analyse zum Auswerten des elektrischen Signals zu verwenden, um niederfrequente Schwingungen zu erkennen.

Bei der vorgeschlagenen Wavelet-Analyse wird ein zeitabhängiges Frequenzbild erstellt. Das erfolgt über eine Korrelationsanalyse des erfassten Signals mit einer vorbestimmten Wavelet-Mutterfunktion. Diese Wavelet-Mutterfunktion wird also vorbestimmt, kann also vorgegeben werden. Sie kann dabei beispielsweise fest vorgegeben sein und hinterlegt sein, oder es kommen auch Veränderungen der Wavelet-Mutterfunktion in Betracht. Es kommt auch in Betracht, mehrere Analysen jeweils durchzuführen, wobei die Analysen jeweils unterschiedliche Wavelet-Mutterfunktionen verwenden.

Jedenfalls ergibt sich bei der Korrelationsanalyse des erfassten Signals mit der vorbestimmten Wavelet-Mutterfunktion ein zeitabhängiges Frequenzbild. In dem zeitabhängigen Frequenzbild werden somit über die Zeit Frequenzen aufgetragen. Beispielsweise kann zur Visualisierung ein Diagramm verwendet werden, das die Abszisse als Zeitachse verwendet und als Ordinate Frequenzwerte aufträgt. Die Werte werden aber nicht als Einzelwerte aufgetragen, sondern vielmehr im Sinne einer Dichte ihres Auftretens, indem beispielsweise eine prozentuale Energie über einen Farbcode zugeordnet werden kann.

Das ist besonders eine grafische Darstellungsart, aber die einer solchen grafischen Darstellung zugrundeliegenden Informationen können auch als Werte oder Wertemenge in einem Prozessrechner weiter ausgewertet werden, auch ohne visualisiert zu werden.

Es wird nun vorgeschlagen, dass vom Vorliegen einer niederfrequenten Schwingung ausgegangen wird, wenn in dem zeitabhängigen Frequenzbild zusätzlich zu einem Grundanteil wenigstens ein weiterer niederfrequenter Frequenzanteil vorhanden ist. Insoweit ist zu wiederholen, dass das zeitabhängige Frequenzbild zwar grafisch dargestellt werden kann, zur weiteren Auswertung aber nicht grafisch dargestellt werden muss. Mit zeitabhängigem Frequenzbild ist hier besonders gemeint, dass sich verschiedene Frequenzen verschiedener Intensität, also verschiedener Amplitude, auch zu unterschiedlichen Zeitpunkten ergeben können. Somit ergibt sich also keine einzelne Zahl und auch keine einzelne zeitabhängige skalare Funktion, sondern zeitabhängige Informationen, nämlich viele Frequenzinformationen zu jeder Zeit. Das wird hier als zeitabhängiges Frequenzbild bezeichnet.

Der Grundanteil ist hier üblicherweise die Netznennfrequenz, wobei aber die tatsächliche Netzfrequenz von der Netznennfrequenz abweichen kann, wobei wohl nur mit geringer Abweichung zu rechnen ist, was sich auch entsprechend in dem zeitabhängigen Frequenzbild wiederspiegeln kann, sofern die Genauigkeit für die Abweichung von der Netznennfrequenz ausreichend ist. Auf diesen Grundanteil kommt es aber nicht an, außer dass dieser leicht identifiziert werden kann und nicht als erkannte niederfrequente Schwingung interpretiert werden sollte. Dieser Grundanteil kann also ignoriert oder bei einer weiteren Auswertung herausgerechnet werden und nur das zusätzlich zu diesem Grundanteil Verbleibende wird untersucht, um die niederfrequenten Schwingungen zu erkennen.

Tritt also beispielsweise eine Frequenz im Bereich von 4 bis 6 Hz in diesem zeitabhängigen Frequenzbild häufig und mit ausreichender Intensität auf, so kann eine niederfrequente Schwingung im Bereich von 4 bis 6 Hz als erkannt gelten. Beispielsweise kann ein Schwellwert für die Intensität zugrunde gelegt werden. Außerdem oder alternativ kann ein über die Zeit verteilter zeitlicher Mindestanteil zugrunde gelegt werden, um von einer erkannten niederfrequenten Schwingung auszugehen. Wenn also beispielsweise in einem betrachteten Zeitraum nur in einem Bereich von 10% des gesamten Zeitraums eine niederfrequente Schwingung aufgetreten ist, so kann das beispielsweise als nicht ausreichend für das Erkennen einer niederfrequenten Schwingung angesehen werden. Tritt sie hingegen zu einem größeren Teil, beispielsweise zu mehr als 50% in dem Zeitbereich auf, so könnte dies als eine Erkennung einer niederfrequenten Schwingung angesehen werden, ggf. aber nur dann, wenn die Intensität ausreichend hoch ist. Dies soll nur zur Veranschaulichung gelten und es können grundsätzlich verschiedene Kriterien, wie beispielsweise verschiedene Schwellen, zugrunde gelegt werden.

Gemäß einer Ausführungsform wird vorgeschlagen, dass zusätzlich geprüft wird, ob der wenigstens eine weitere niederfrequente Frequenzanteil aperiodisch schwankt. Besonders wurde erkannt, dass die vorgeschlagene Auswertung des elektrischen Signals mittels der Wavelet-Analyse zu dem zeitabhängigen Frequenzbild führt und dieses zeitabhängige Frequenzbild unmittelbar ermöglicht, nicht nur das Auftreten weiterer niederfrequenter Frequenzen zu erfassen, sondern auch ihre Verteilung über die Zeit zu betrachten. Besonders ist eine aperiodische Schwankung insoweit eine Veränderung dieses wenigstens einen weiteren niederfrequenten Frequenzanteils über die Zeit. Dieser Frequenzanteil liegt also nicht dauerhaft vor, sondern verändert sich, wobei die Veränderung nicht periodisch ist. Damit können besonders auch niederfrequente Frequenzanteile erfasst werden, die nicht dauerhaft vorhanden sind.

Aber auch periodisch schwankende Frequenzanteile, also Frequenzanteile, die nicht dauerhaft auftreten, aber periodisch nicht dauerhaft oder schwächer auftreten, können hierdurch erfasst werden und für die Beurteilung des Netzzustandes relevant sein.

Gemäß einer weiteren Ausgestaltung wird vorgeschlagen, dass ein zeitlicher Verlauf einer Amplitude des wenigstens einen weiteren Frequenzanteils erfasst wird. Auch diese Information lässt sich vorteilhafterweise dem zeitabhängigen Frequenzbild entnehmen. Durch die Erfassung dieses Verlaufs der Amplitude des weiteren Frequenzanteils kann besonders die Veränderung des Frequenzanteils erkannt werden. Insbesondere kann erkannt werden, ob die Amplitude zunimmt oder abnimmt. Besonders dann, wenn die Amplitude zunimmt, also mit der Zeit zunimmt, kann auf eine kritische Situation geschlossen werden, die ggf. ein Eingreifen auslösen sollte. Abhängig einer zeitlich zunehmenden Amplitude eines weiteren Frequenzanteils sollten dann bedämpfende Maßnahmen durchgeführt werden, insbesondere sollte ein bedämpfendes elektrisches Signal in das elektrische Versorgungsnetz eingespeist werden.

Es kommt aber auch in Betracht, dass sich die Amplitude verändert, ohne eine klare Tendenz zum Abnehmen oder Zunehmen zu zeigen. Aus der Art der Veränderung der Amplitude können ggf. Rückschlüsse auf die Situation im elektrischen Versorgungsnetz gezogen werden.

Gemäß einer Ausführungsform wird vorgeschlagen, dass für das Auswerten des elektrischen Signals ein Prüffrequenzbereich zugrunde gelegt wird. Dieser Prüffrequenzbereich gibt somit den Frequenzbereich vor, in dem nach den niederfrequenten Schwingungen gesucht wird.

Es wird vorgeschlagen, dass der Prüfbereich von einer Frequenzuntergrenze bis zu einer Frequenzobergrenze reicht. Er wird also durch diese Frequenzuntergrenze und die Frequenzobergrenze festgelegt. Die Frequenzuntergrenze liegt dabei in einem Bereich von 0,1 Hz bis 2 Hz und insbesondere wird vorgeschlagen, als Frequenzuntergrenze den Wert 1 Hz zu wählen.

Die Frequenzobergrenze liegt in einem Bereich von einem Wert der Nennfrequenz bis zu einem fünffachen Wert der Nennfrequenz. Insbesondere wird als Frequenzobergrenze der Wert der Nennfrequenz gewählt. Insbesondere reicht somit der Prüffrequenzbereich von 1 Hz bis Nennfrequenz, also reicht er für übliche elektrische Versorgungsnetze von 1 Hz bis 50 Hz oder von 1 Hz bis 60 Hz.

Die Festlegung des Prüffrequenzbereichs kann besonders dadurch erfolgen, dass ein entsprechender Zeitraum gewählt wird, für den das elektrische Signal zur Auswertung aufgenommen wird. Natürlich kann das elektrische Signal auch länger aufgenommen werden und es kann dann von dem Signal ein entsprechender Zeitabschnitt als auszuwertendes elektrisches Signal bzw. als auszuwertender elektrischer Signalabschnitt verwendet werden. Es kommt auch in Betracht, dass ein solcher Zeitraum des auszuwertenden Signals wie ein Fenster ständig über ein dauerhaft aufgenommenes elektrisches Signal verschoben wird und dadurch bei gleicher Zeitraumlänge ständig eine neue Auswertung vorgenommen werden kann.

Der Prüffrequenzbereich wird dann natürlich auch durch die Abtastfrequenz mitbestimmt. Besonders ist wenigstens mit der doppelten Frequenz der Frequenzobergrenze abzutasten. Um den Frequenzbereich der Frequenzuntergrenze erfassen zu können, muss wenigstens ein Zeitraum des elektrischen Signals ausgewertet werden, der dem Kehrwert der Frequenzuntergrenze entspricht. Soll also die Frequenzuntergrenze 0,1 Hz betragen, so muss wenigstens über einen Zeitraum von 10 s das Signal ausgewertet werden.

Weiterhin wird auch vorgeschlagen, dass die zu wählende Wavelet-Mutterfunktion besonders in ihrer zeitlichen Ausdehnung an den Prüffrequenzbereich angepasst ist, denn sie beeinflusst, welcher Frequenzbereich bei der Korrelationsanalyse auf die Wavelet-Mutterfunktion anspricht.

Vorzugsweise wird vorgeschlagen, dass die Wavelet-Mutterfunktion nach der erwarteten Schwingungsform ausgewählt wird. Dadurch kann eine besonders schnelle Erfassung erreicht werden, denn es braucht nicht nach einer beliebigen Schwingung gesucht zu werden.

Vorzugsweise ist das Verfahren dadurch gekennzeichnet, dass als elektrisches Signal eine dreiphasige Spannung, insbesondere die Netzspannung, erfasst wird und die so erfasste dreiphasige Spannung gefiltert oder transformiert wird, und die Wavelet-Analyse auf das gefilterte bzw. transformierte Signal angewendet wird. Besonders wird die beschriebene Korrelation mit der vorbestimmten Wavelet-Mutterfunktion mit diesem transformierten bzw. gefilterten Signal durchgeführt. Eine Transformation des erfassten dreiphasigen Signals, also der erfassten dreiphasigen Spannung, kann insbesondere bedeuten, dass eine Transformation in eine d/q-Darstellung erfolgt. In einer solchen bekannten d/q-Darstellung kann das dreiphasige Signal durch eine d-Komponente und eine q-Komponente dargestellt werden. Vorzugsweise ist die Wavelet-Mutterfunktion bei ihrer Anwendung zur Analyse, also insbesondere für die Korrelation an die Darstellung des dreiphasigen Signals in der d/q-Darstellung angepasst.

Durch die Transformation in die genannte d/q-Darstellung kann somit auch erreicht werden, dass die drei Spannungssignale des dreiphasigen Signals gemeinsam betrachtet werden können.

Es kommt aber auch eine Filterung in Betracht, die beispielsweise als Bandpassfilter oder Tiefpassfilter ausgebildet ist, um nicht zu beachtende Frequenzbereiche herauszufiltern, so dass diese bei der Wavelet-Analyse nicht berücksichtigt zu werden brauchen. Auch das ist eine Möglichkeit, einen Prüffrequenzbereich festzulegen. Dabei ist es häufig ausreichend, hohe Frequenzen, die nicht untersucht zu werden brauchen, durch die Filterung auszuschließen oder zumindest signifikant zu verringern. Sehr niedrige Frequenzen, also unterhalb des gewünschten Prüffrequenzbereichs, sind regelmäßig in einem solchen Signal nicht vorhanden oder sind schon dadurch ausgeschlossen, dass der Messzeitraum entsprechend kurz ist.

Besonders für das Erfassen einer Leistungsschwingung wird das Transformieren vorgeschlagen, nämlich für entsprechende Ströme und Spannung eine d/q-Transformation vorzunehmen, und dann aus den transformierten Strömen und Spannungen die Leistungen zu berechnen. Dadurch kann besonders gut eine Funktion einer Leistung oder ein Leistungsverlauf bestimmt werden, auf den eine Wavelet-Mutterfunktion angewendet werden kann.

Gemäß einer Ausführungsform wird vorgeschlagen, dass die Wavelet-Mutterfunktion wenigstens eine Eigenschaft aufweist aus der folgenden Liste:
1. Die Wavelet-Mutterfunktion ist dazu vorbereitet, skalierbar zu sein.
   Die Wavelet-Mutterfunktion ist besonders als Zeitsignal beschreibbar, also als eine über die Zeit veränderliche Funktion, wie beispielsweise: $f \left(t\right) = cos \left(k⋅t\right) ⋅ \frac{1}{{\left(k⋅t\right)}^{2} + 1}$
   In dieser Formel soll die Funktion f(t) die Wavelet-Mutterfunktion bilden und diese Funktion wäre skalierbar, besonders auch nach der Zeit skalierbar. Das kann dadurch erreicht werden, dass in dieser beispielhaften Wavelet-Mutterfunktion der Faktor k entsprechend gewählt wird. Beispielsweise kann diese Wavelet-Mutterfunktion mit dem Faktor k=1 als Grundfunktion oder als unskalierte Funktion bezeichnet werden und durch Veränderung des Faktors k kann die Skalierung vorgenommen werden. Wird beispielsweise als Faktor k=2 gewählt, ergäbe sich eine Stauchung dieser Wavelet-Mutterfunktion.
   Aber auch eine Betrachtung derselben Wavelet-Mutterfunktion im Frequenzbereich führt dazu, dass durch Veränderung des Faktors k die Funktion nach der Frequenz skaliert werden kann, also nach der Frequenz gestaucht oder gedehnt werden kann.
   Die Wavelet-Mutterfunktion ist also dadurch dazu vorbereitet, skalierbar zu sein. Dafür ist der in dem Beispiel gezeigte Faktor k vorgesehen, über den die Skalierung erreicht wird.
   Durch diese Skalierbarkeit nach der Zeit oder der Frequenz können unterschiedliche Frequenzen erfasst werden. Besonders kann hierüber, oder u.a. hierüber, die Wahl des Prüffrequenzbereichs umgesetzt werden.
2. Die Wavelet-Mutterfunktion ist dazu vorbereitet, zeitlich verschiebbar zu sein.
   Das kann beispielsweise bedeuten, dass in der oben gezeigten veranschaulichenden Beispielwavelet-Mutterfunktion anstelle der Zeit t eine Zeit mit einem Offset verwendet wird. In der Formel kann also beispielsweise "t" durch "t+t₀" ersetzt werden. Das führt dann zu einer Verschiebung um die Zeit t₀, wobei diese Zeit t₀ auch negativ sein kann. Durch eine solche Verschiebung der Wavelet-Mutterfunktion kann ggf. besser eine Information erhalten werden, wann die jeweilige Frequenz, also die zu erkennende niederfrequente Schwingung, auftritt. Vorzugsweise wird eine Wavelet-Analyse mit derselben Wavelet-Mutterfunktion mehrfach durchgeführt, wobei als einziger Unterschied aber jeweils eine zeitlich verschobene Wavelet-Mutterfunktion verwendet wird. Dadurch können dann mehrere zeitabhängige Frequenzbilder erstellt werden und darin können dann ggf. dominante niederfrequente Schwingungen, also dominante niedrige Frequenzen an unterschiedlichen Stellen aber auch mit unterschiedlicher Ausprägung auftreten, je nachdem, wie die verwendete Wavelet-Mutterfunktion zeitlich in Bezug auf das analysierte Signal gelegen hat. Etwas anschaulich ausgesprochen kann diese niederfrequente Schwingung bzw. diese niedrige Frequenz in dem zeitabhängigen Frequenzbild unterschiedlich stark auftreten, abhängig davon, wie sehr sie im Zentrum der Wavelet-Mutterfunktion aufgetreten ist.
3. Die Wavelet-Funktion weist Lokalität sowohl im Frequenzbereich als auch im Zeitbereich auf. Unter Lokalität ist hier zu verstehen, dass die Wavelet-Mutterfunktion nicht gleich verteilt ist, also weder im Zeitbereich gleich verteilt ist, als auch im Frequenzbereich gleich verteilt ist. Beispielsweise ist eine Sinusfunktion im Zeitbereich gleich verteilt und weist somit keine Lokalität im Zeitbereich auf, denn sie oszilliert gleichmäßig mit gleicher Amplitude über den gesamten betrachteten Bereich. Ein Dirac-Impuls weist eine (starke) Lokalität im Zeitbereich auf, ist aber - zumindest theoretisch - im Frequenzbereich ohne Lokalität, denn er entspricht im Frequenzbereich einem weißen Rauschen.
   Hier wird aber vorgeschlagen, dass sowohl im Frequenzbereich als auch im Zeitbereich Lokalität vorhanden ist. Diese Eigenschaft erfüllt beispielsweise die oben genannte Beispielfunktion. Sie weist nämlich für t=0 den größten Wert auf, der an keiner anderen Stelle erreicht wird. Somit weist sie im Bereich t=0 ihre Lokalität auf. Außerhalb von diesem Bereich existiert sie auch, klingt aber mit zunehmender Zeit ab bzw. auch in negative Richtung mit zunehmendem Zeitabstand.
   Im Frequenzbereich weist diese beispielhafte Wavelet-Mutterfunktion auch Lokalität auf, weil sie nämlich ihre Hauptausprägung bei der Frequenz der dort verwendeten cos-Funktion aufweist. Vorsorglich wird darauf hingewiesen, dass die oben genannte veranschaulichende Beispielwavelet-Mutterfunktion natürlich nicht präzise angegeben ist, denn dort hängt die cos-Funktion von der Zeit ab, müsste also bei der tatsächlichen Umsetzung noch auf eine Zeit bzw. Grundfrequenz normiert werden. Würde sie beispielsweise auf 1 Hz als Grundfrequenz normiert bzw. bezogen werden, so wäre ihr größter Wert entsprechend bei 1 Hz im Frequenzbereich.
   Mit dieser Lokalität wird besonders auch erreicht, dass bei der Wavelet-Analyse des erfassten elektrischen Signals dessen zeitliche Inhomogenität erfasst wird. Mit anderen Worten kann dadurch besonders gut erfasst werden, wann eine niederfrequente Schwingung bzw. die entsprechend niedrige Frequenz auftritt.
4. Vorzugsweise weist die Wavelet-Mutterfunktion ein Integral auf, das null ist. Wird also ein Integral über die gesamte verwendete Wavelet-Mutterfunktion gebildet, ist das Ergebnis null. Dadurch wird besonders trotz Lokalität der Wavelet-Mutterfunktion erreicht, dass diese im Zeitbereich ausgewogen im positiven und negativen Bereich, also anschaulich gesprochen über und unter der Zeitachse, ausgebildet ist. Das kann besonders auch bei der Verwendung im Frequenzbereich bzw. bei der Transformation von dem Zeitbereich in den Frequenzbereich vorteilhaft sein, weil quasi ein Gleichanteil vermieden wird.
5. Als Wavelet-Mutterfunktion wird ein Morlet-Wavelet, Daubechies D20-Wavelet oder ein mexikanischer Hut verwendet. Diese Wavelet-Funktionen sind dem Fachmann grundsätzlich bekannt, hier wurde aber erkannt, dass diese besonders gut für das Erkennen der niederfrequenten Schwingungen sinnvoll sind. Der mexikanische Hut kann im Übrigen durch die oben genannte veranschaulichende Beispielmutter-Wavelet-Funktion definiert werden.

Gemäß einer Ausführungsform wird vorgeschlagen, dass eine Wavelet-Mutterfunktion in Abhängigkeit eines Auswahlkriteriums aus mehreren vorbestimmten Wavelet-Funktionen ausgewählt wird. Außerdem oder alternativ wird die Wavelet-Mutterfunktion in Abhängigkeit eines Auswahlkriteriums parametriert. Ein solches Auswahlkriterium kann selbst mehrere Einzelkriteria oder mehrere Werte beinhalten, die zur Auswahl aus den Wavelet-Funktionen bzw. zur Parametrierung berücksichtigt werden. Als Auswahlkriterium kommt beispielsweise in Betracht, den Prüffrequenzbereich zu berücksichtigen. So kann abhängig des Prüffrequenzbereichs die Wavelet-Funktion ausgewählt werden. Z.B. kann eine Wavelet-Funktion ausgewählt werden, die über einen Zeitbereich definiert ist, der aufgrund seiner Länge zum Prüffrequenzbereich passt, um nur ein Beispiel zu nennen. Ebenso oder zusätzlich kann in diesem Sinne auch eine Parametrierung der Wavelet-Funktion vorgenommen werden. Besonders bei einer streckbaren Wavelet-Funktion kann ein entsprechender Streckungsparameter so ausgewählt werden, dass die Wavelet-Funktion zu dem Prüffrequenzbereich passt, um ein weiteres anschauliches Beispiel zu nennen.

Vorzugsweise wird aber vorgeschlagen, dass das Auswahlkriterium wenigstens einen Erwartungswert des elektrischen Signals aufweist. Das bedeutet besonders, dass hier bereits eine niederfrequente Schwingung erwartet wird, weil sie beispielsweise früher schon einmal aufgetreten ist. Insoweit kann hier auch die Auswahl und/oder Parametrierung in Abhängigkeit eines Erfahrungswertes des elektrischen Signals vorgenommen werden.

Der Erwartungswert des elektrischen Signals kann somit beispielsweise einen konkreten Frequenzwert oder einen Frequenzbereich betreffen, für den bzw. in dem eine niederfrequente Schwingung bereits aufgetreten ist. Ggf. sind auch Zeiten bekannt, wann eine solche niederfrequente Schwingung auftritt und auch das kann dann bei der Auswahl und/oder Parametrierung der Wavelet-Funktion für die Wavelet-Mutterfunktion berücksichtigt werden. Es kommt auch in Betracht, dass, um ein weiteres Beispiel zu nennen, mit mehreren niederfrequenten Schwingungen zu rechnen ist und auch daran kann die Wavelet-Mutterfunktion entsprechend angepasst sein.

Insbesondere wird vorgeschlagen, dass abhängig von dem Erwartungswert bzw. generell dem zu erwartenden elektrischen Signal zunächst strukturell eine von mehreren vorbestimmten Wavelet-Funktionen ausgewählt wird. Beispielsweise kommen unterschiedliche Wavelet-Funktionen in Betracht, abhängig davon, ob mit einer oder mehreren niederfrequenten Schwingungen zu rechnen ist.

Nach Vornahme einer solchen Auswahl abhängig einer strukturellen Betrachtung, kann dann eine Parametrierung der Wavelet-Funktion vorgenommen bzw. verändert werden. Hier kommt insbesondere auch eine Streckung oder Stauchung in Betracht. Das Kriterium hierfür kann besonders ein zu erwartender Frequenzbereich oder eine konkrete zu erwartende Frequenz sein.

Entsprechend kann also eine Wavelet-Mutterfunktion in Abhängigkeit eines Auswahlkriteriums bestimmt werden, wobei das Auswahlkriterium mehrere Einzelinformationen betrachtet. In dem genannten Beispiel waren das die beiden Informationen, ob eine oder mehrere niederfrequente Schwingungen erwartet werden und welcher Frequenzbereich relevant ist. Davon abhängig wurde die Wavelet-Funktion zunächst ausgewählt und dann parametriert.

Gemäß einer Ausführungsform wird vorgeschlagen, dass das Verfahren an einem Netzanschlusspunkt vorgenommen wird, an dem wenigstens eine dezentrale Erzeugungseinheit in das elektrische Versorgungsnetz einspeist. Eine solche dezentrale Erzeugungseinheit kann insbesondere eine Windenergieanlage sein, oder ein Windpark, der mehrere Windenergieanlagen umfasst. Dazu wird vorgeschlagen, dass zur Erkennung der niederfrequenten Schwingungen wenigstens eine elektrische Größe der Einspeisung aufgenommen wird und mittels einer bzw. der genannten Wavelet-Analyse ausgewertet wird. Die Auswertung bzw. Analyse kann natürlich auch indirekt auf diese wenigstens eine aufgenommene elektrische Größe angewendet werden, wenn die elektrische Größe der Einspeisung dafür beispielsweise zunächst transformiert wurde.

Durch die Verwendung einer solchen elektrischen Größe der Einspeisung wird somit die dezentrale Erzeugungseinheit zum Erkennen der niederfrequenten Schwingung verwendet. Das hat besonders den Vorteil, dass diese dezentrale Erzeugungseinheit ohnehin vorhanden ist und regelmäßig auch ausreichende Messaufnehmer aufweist, die dann zusätzlich dazu verwendet werden können, die wenigstens eine elektrische Größe der Einspeisung aufzunehmen. Es kommt auch in Betracht, dass eine solche wenigstens eine elektrische Größe der Einspeisung in der dezentralen Erzeugungseinheit, insbesondere in einer entsprechenden Steuerungseinheit, ohnehin als Größe vorhanden ist und dann diese ohnehin vorhandene Größe mittels der Wavelet-Analyse ausgewertet werden kann.

Es ist zu beachten, dass diese wenigstens eine elektrische Größe der Einspeisung auch das bereits genannte elektrische Signal des elektrischen Versorgungsnetzes sein kann. Besonders eine Spannung am Netzanschlusspunkt oder eine entsprechende Spannung an einem Ausgang der dezentralen Erzeugungseinheit, wäre eine Spannung, bei der die dezentrale Erzeugungseinheit elektrischen Strom in das elektrische Versorgungsnetz einspeist.

Die Verwendung dieser dezentralen Erzeugungseinheit kann außerdem den Vorteil haben, dass bei dem Erkennen einer niederfrequenten Schwingung, die nach Art und Amplitude so ausgebildet ist, dass eine Bedämpfung ratsam ist, die dezentrale Erzeugungseinheit eine solche Bedämpfung auch vornehmen kann. Vorzugsweise passt die dezentrale Erzeugungseinheit dafür ihr Einspeisen, insbesondere das Einspeisen eines elektrischen Stroms, so an, dass die erkannte niederfrequente Schwingung bedämpft wird. Insbesondere verändert die dezentrale Erzeugungseinheit einen Wirkleistungsanteil der eingespeisten Wirkleistung so, dass die erkannte niederfrequente Schwingung bedämpft wird.

Die wenigstens eine elektrische Größe, die aufgenommen wird, kann der eingespeiste Strom sein, die eingespeiste Blindleistung, die eingespeiste Wirkleistung, oder die bereits genannte Spannung am Netzanschlusspunkt oder eine dazu proportionale Spannung, bei der die dezentrale Erzeugungseinheit elektrischen Strom in das elektrische Versorgungsnetz einspeist. Grundsätzlich können auch mehrere dieser Größen aufgenommen werden und beispielsweise getrennt einer Wavelet-Analyse unterzogen werden. Das kann den Vorteil haben, dass manche Schwingungen in einer der genannten elektrischen Größen stärker auftritt oder besser erkannt werden kann.

Vorzugsweise wird die Spannung am Netzanschlusspunkt ausgewertet, weil besonders niederfrequente Schwingungen in der Spannung auftreten können.

Die Verwendung des eingespeisten Stroms kann besonders dann vorteilhaft sein, wenn die Spannung oder zumindest eine Spannungsmessung durch hochfrequente Signale gestört ist oder solche hochfrequenten Signale überlagert sind. Mitunter können solche hochfrequenten Signale nicht oder weniger in dem eingespeisten Strom auftreten, der gleichwohl die niederfrequente Schwingung aufweisen kann.

Auch die Verwendung der eingespeisten Blindleistung kann eine solche niederfrequente Schwingung der Netzspannung, also auch der Spannung am Netzanschlusspunkt wiederspiegeln. Die eingespeiste Blindleistung ist dabei nicht oder zumindest weniger von Leistungsschwankungen betroffen, die bei Windenergieanlagen besonders durch Schwankungen im Wind hervorgerufen sein können. Es kommt auch in Betracht, dass die dezentrale Erzeugungseinheit in einem sogenannten STATCOM-Betrieb arbeitet, in dem keine Wirkleistung eingespeist wird. Ein solcher Betrieb kann auch besonders dann vorliegen, wenn mangels Wind, wenn die dezentrale Erzeugungseinheit eine Windenergieanlage ist, keine Wirkleistung eingespeist werden kann. In diesem Fall kann aber noch Blindleistung eingespeist werden und diese kann Aufschluss über eine niederfrequente Schwingung geben.

Die Verwendung der eingespeisten Wirkleistung kann besonders dann vorteilhaft sein, wenn die niederfrequenten Schwingungen einhergehen mit oder ausgelöst sind durch subsynchrone Resonanzen, bei denen Energie bzw. Leistung im elektrischen Versorgungsnetz hin- und herschwingt.

Gemäß einer Ausgestaltung wird ein Verfahren vorgeschlagen, das dadurch gekennzeichnet ist, dass die erkannte niederfrequente Schwingung als Netzschwingung betrachtet wird, eine Windenergieanlage vorgesehen ist, die einen Rotor mit Rotorblättern, einen Generator und einen Wechselrichter zum Einspeisen elektrischer Leistung in das elektrische Versorgungsnetz aufweist, und wobei zusätzlich erfasst wird, ob die Windenergieanlage an der Netzschwingung teilnimmt. Dazu wird weiter vorgeschlagen, dass mittels einer Wavelet-Analyse eine niederfrequente Schwingung der Windenergieanlage als Anlagenschwingung erfasst wird, insbesondere an einer Zwischenkreisspannung an einem Gleichspannungszwischenkreis des Wechselrichters, und dass überprüft wird, ob die Netzschwingung und die Anlagenschwingung korrelieren. Es wird davon ausgegangen, dass die Windenergieanlage an der Netzschwingung teilnimmt, wenn die Netzschwingung und die Anlagenschwingung korrelieren.

Es wurde erkannt, dass Netzschwingungen für eine Windenergieanlage oder einen Windpark, sehr unterschiedliche Relevanz haben können und in Bezug auf diese Relevanz in zwei Kategorien eingeteilt werden können. Demnach wird vorgeschlagen, zu unterscheiden, ob eine Windenergieanlage an einer niederfrequenten Schwingung im elektrischen Versorgungsnetz, also an einer Netzschwingung, teilnimmt, oder nicht. Wenn die Windenergieanlage an der Netzschwingung teilnimmt, bedeutet das, dass sie selbst diese Schwingung aufweist und besonders auch zu einer solchen Netzschwingung beiträgt. Es gibt also einer Interaktion zwischen der Netzschwingung und einer Schwingung der Windenergieanlage.

Eine moderne Windenergieanlage, die hier zu Grunde gelegt wird, weist einen Rotor mit Rotorblättern, einen Generator und einen Wechselrichter zum Einspeisen elektrischer Leistung in das elektrische Versorgungsnetz auf. Es wurde erkannt, dass besonders diese Elemente schwingen können und/oder die Schwingung beeinflussen können.

Um diese Kategorien zu unterscheiden sollte zunächst erkannt werden, welche Kategorie aktuell vorliegt. Dazu wird zusätzlich zu einer erkannten Netzschwingung auf eine niederfrequente Schwingung in der Windenergieanlage geprüft, die somit als Anlagenschwingung bezeichnet wird. Auch dafür wird die Verwendung einer Wavelet-Analyse vorgeschlagen. Dazu wird ein Signal der Windenergieanlage untersucht, und vorzugsweise kann dafür die Zwischenkreisspannung des Wechselrichters verwendet werden. Es wurde erkannt, dass diese gut geeignet ist, eine Anlagenschwingung zu erkennen. Das liegt besonders auch daran, dass sich sowohl Schwingungen des Einspeisens, als auch des Generators und ggf. auch mechanische Schwingungen in Schwankungen der Spannung des Gleichspannungszwischenkreises wiederspiegeln. Zudem kann die Zwischenkreisspannung gut gemessen werden.

Somit sind mittels Wavelet-Analyse sowohl die Netzschwingung als auch die Anlagenschwingung erfasst worden und können verglichen werden. Die Verwendung der Wavelet-Analyse ermöglicht auch die Erfassung von Veränderungen jeder der Schwingungen über die Zeit. Auch das kann für beide Schwingungen verglichen werden.

Es wurde nun erkannt, dass die Windenergieanlage an der Netzschwingung teilnimmt, wenn diese beiden Schwingungen korrelieren. Besonders ist das der Fall, wenn ihre Frequenzen korrelieren. Es kann aber auch einer Korrelation zwischen dem zeitlichen Auftreten beider Schwingungen betrachtet werden. Durch die Wavelet-Analyse kann erkannt werden, wann die jeweiligen Schwingungen aufgetreten sind und darauf basierend kann dann die zeitliche Korrelation beider Schwingungen geprüft werden.

Abhängig davon, ob die Windenergieanlage an der Schwingung teilnimmt, können angepasste Maßnahmen ergriffen werden. Nimmt die Windenergieanlage an der Netzschwingung teil, so ist besonders ihre eigene Schwingung bzw. ihr eigener Schwingungsanteil zu bedämpfen. Nimmt sie nicht teil, so kann sie dennoch einen Dämpfungsbeitrag leisten, der sich aber besonders auf eingespeiste Größen konzentriert und Dynamiken des elektrischen Versorgungsnetzes berücksichtigt.

Vorzugsweise wird vorgeschlagen, dass wenn darauf erkannt wurde, dass die Windenergieanlage an der Netzschwingung teilnimmt, die Anlagenschwingung darauf überprüft wird, ob sie eine vorgegebene Schwingungsamplitude übersteigt. Gegenüber der Überprüfung auf Korrelation zwischen der Netzschwingung und er Anlagenschwingung kommt somit noch eine Prüfung auf eine Schwingungsamplitude hinzu. Es werden dann Dämpfungsmaßnahmen eingeleitet, wenn die Anlagenschwingung die vorgegebene Schwingungsamplitude übersteigt.

Als Dämpfungsmaßnahmen kommen die folgenden in Betracht, wobei auch mehrere kombiniert werden können.

Eine Dämpfungsmaßnahme ist eine Erhöhung eines Dämpfungsanteils einer Regelung des Generators, insbesondere eines Statorstroms des Generators. Über den Statorstrom oder eine Leistungsabgabe des Generators kann der Generator gesteuert werden. Darüber kann bspw. das Generatormoment eingestellt werden. Das Generatormoment kann abhängig einer Drehzahl des aerodynamischen Rotors und damit auf abhängig der Drehzahl des Generators eingestellt werden, wobei das Generatormoment dann wieder Einfluss auf die Drehzahl hat. Das System kann somit schwingen und das kann durch eine entsprechende Regelung verstärkt oder bedämpft werden. Diese Regelung kann über einen aktiven Gleichrichter erfolgen, der den Statorstrom gleichrichtet.

Wird der Statorstrom geregelt, hat das auch Einfluss auf den Gleichspannungszwischenkreis, in den der Statorstrom vom Generator über einen Gleichrichter gelangt. Dadurch kann die Zwischenkreisspannung auch geregelt werden und durch eine entsprechende Reglerparametrierung kann eine dämpfende Eigenschaft im Vordergrund stehen.

Eine weitere Dämpfungsmaßnahme ist das Verwenden einer Pitchregelung zum Einstellen eines Blattwinkels der Rotorblätter, wobei ein Dämpfungsanteil erhöht oder eingestellt wird. Besonders bei Leistungsveränderungen kann eine Pitchregelung vorgesehen sein, die durch das Verstellen der Rotorblätter in ihrem Blattwinkel die Energie steuern kann, die der Rotor aus dem Wind entnimmt. Schwankt die Leistung der Windenergieanlage, ohne dass dies Schwankungen im Wind wiederspiegelt, so kann dieser Schwankung durch eine Pitchregelung entgegengewirkt werden. Dabei ist besonders auch eine Dynamik des Rotors und auch der Rotorblätter und ihrer Verstellantriebe zum Verstellen der Blattwinkel zu beachten. Das ist bei der Pitchregelung zu beachten und die Regelung kann zum Zwecke der Bedämpfung langsamer eingestellt werden.

Eine weitere Dämpfungsmaßnahme ist eine Erhöhung eines Dämpfungsanteils einer Einspeiseregelung zum Steuern des Wechselrichters zum Einspeisen in das elektrische Versorgungsnetz. Demnach ist eine Regelung des Einspeisens vorgesehen, die besonders eine einzuspeisende Leistung, insbesondere einen einzuspeisenden Strom regelt. Hier kann im Vordergrund stehen, die Einspeisung möglichst konstant zu halten. Auch dabei können Schwingungen auftreten und die können durch eine entsprechende Parametrierung bedämpft werden, indem z.B. eine Zeitkonstante erhöht wird, oder in der Auslegung des Reglers ein Eigenwertpaar in einen schwingungsärmeren Bereich verschoben wird.

Eine weitere Dämpfungsmaßnahme ist eine Verschiebung eines Arbeitspunktes der Einspeisung, insbesondere durch eine Reduzierung der eingespeisten Leistung. Hier kann bereits eine stationäre Leistungsreduzierung zu einer Schwingungsbedämpfung oder Reduzierung führen, wenn dadurch das elektrische Versorgungsnetz entlastet wird. Das kann auch einhergehen mit einer Erhöhung der Blindleistung, die dadurch möglich wird und zu einer Reduzierung von Schwingungen führt. Generell kann die Verschiebung des Arbeitspunktes dazu führen, dass dieser einen größeren Abstand zu Stabilitätsgrenzen erhält und dadurch Schwingungsmindernd wirkt.

Auch werden Grenzzyklen vermieden, die durch das Erreichen von Begrenzungen entstehen können. Durch die Verschiebung des Arbeitspunktes kann dieser einen größeren Abstand zu solchen Grenzen haben, was das Auftreten von Grenzzyklen vermeidet.

Eine weitere Dämpfungsmaßnahme ist eine Aktivierung einer Stromregelung des Wechselrichters zur Steuerung eines Einspeisestroms, wobei ein Dämpfungsanteil erhöht oder eingestellt wird. Auch durch die Anwendung einer Stromregelung des eingespeisten Stroms kann zumindest eine Schwingung des eingespeisten Stroms ausgeregelt oder bedämpft werden, und das kann über einen entsprechend eingestellten Dämpfungsanteil erreicht werden.

Gemäß einer weiteren Ausführungsform wird ein Verfahren vorgeschlagen, das dadurch gekennzeichnet ist, dass das wenigstens eine elektrische Signal mittels einer mit einer Abtastfrequenz abtastenden Messung erfasst wird, um jeweils ein Abtastsignal des elektrischen Signals zu erhalten. Dazu wird vorgeschlagen, dass die Abtastfrequenz um ein Vielfaches über dem Grundanteil liegt, insbesondere wenigstens einen zehnfachen Wert des Grundanteils aufweist, um einen transienten Charakter des elektrischen Signals zu erfassen, wobei zum Auswerten des elektrischen Signals jeweils das Abtastsignal mittels der Wavelet-Analyse ausgewertet wird, insbesondere ohne eine den transienten Charakter des elektrischen Signals verändernden Filterung.

Somit wird das auszuwertende Signal direkt abgetastet und fließt in die Wavelet-Analyse ein. Dadurch kann ein zeitlicher Verlauf des auszuwertenden Signals gut aufgenommen und ausgewertet werden. Das hat bspw. gegenüber einer Anwendung des Prony-Verfahrens den Vorteil, dass noch alle Informationen in dem Signal vorhanden sind, wenn es zur Auswertung in die Wavelet-Analyse einfließt.

Erfindungsgemäß wird auch eine Erkennungseinrichtung zum Erkennen niederfrequenter Schwingungen, insbesondere subsynchroner Resonanzen in einem elektrischen Versorgungsnetz vorgeschlagen. Diese Erkennungseinrichtung geht von einem elektrischen Versorgungsnetz aus, das eine Netzspannung mit einer Netznennfrequenz aufweist. Auch wird zugrunde gelegt, dass die zu erkennenden niederfrequenten Schwingungen eine geringere Frequenz als die Netznennfrequenz aufweisen. Diese Erkennungseinrichtung umfasst eine Erfassungseinrichtung zum Erfassen wenigstens eines elektrischen Signals des elektrischen Versorgungsnetzes. Besonders kann diese Erfassungseinrichtung als Messmittel oder Messsensor ausgebildet sein. Der Messsensor oder die Messeinrichtung kann insbesondere eine Spannungsmesseinrichtung sein, zum Erfassen einer elektrischen Spannung an einem Netzanschlusspunkt.

Außerdem ist eine Auswerteeinrichtung vorhanden, die zum Auswerten des elektrischen Signals eingerichtet ist. Dabei ist sie so eingerichtet, dass die Auswertung mittels einer Wavelet-Analyse durchgeführt wird, bei der über eine Korrelationsanalyse des erfassten Signals mit einer vorbestimmten Wavelet-Mutterfunktion ein zeitabhängiges Frequenzbild erstellt wird. Insbesondere weist die Auswerteeinrichtung hierfür einen Mikroprozessor oder Prozessrechner auf, in dem eine entsprechende Wavelet-Analyse, insbesondere die genannte Korrelationsanalyse, implementiert ist. Das beinhaltet auch, dass das zeitabhängige Frequenzbild erstellt wird. Vorzugsweise kann ein solches zeitabhängiges Frequenzbild auch grafisch ausgegeben werden. Insbesondere erstellt die Auswerteeinrichtung aber ein solches zeitabhängiges Frequenzbild als entsprechenden Datensatz, der zur weiteren Auswertung weiterverarbeitet werden kann.

Dazu ist nämlich die Auswerteeinrichtung auch dazu eingerichtet, dass sie auf das Vorliegen einer niederfrequenten Schwingung erkennt, wenn in dem zeitabhängigen Frequenzbild zusätzlich zu einem Grundanteil wenigstens ein weiterer niederfrequenter Frequenzanteil vorhanden ist. Insbesondere ist auch diese Analyse, die auf diesen zusätzlichen weiteren niederfrequenten Frequenzanteil prüft, in der Auswerteeinrichtung, insbesondere dem Mikroprozessor oder Prozessrechner implementiert. Die Implementierung kann so vorgesehen sein, dass sie in einem weiteren Funktionsblock vorgesehen ist, an den das zeitabhängige Frequenzbild übergeben wird. Das hat besonders den Vorteil, dass das zeitabhängige Frequenzbild zusätzlich zu dieser rechnergestützten weiteren Auswertung auch grafisch ausgegeben werden kann, insbesondere auf einem Monitor oder Drucker, insbesondere Farbdrucker. Vorzugsweise ist auch eine Ausgabeschnittstelle vorgesehen, um das erstellte zeitabhängige Frequenzbild an eine Zentraleinheit zu übertragen. Eine Zentraleinheit kann dann, ggf. ergänzend, eine automatische oder manuelle Auswertung oder Überprüfung dieses zeitabhängigen Frequenzbildes vornehmen.

Gemäß einer Ausführungsform wird vorgeschlagen, dass die Erkennungseinrichtung an einem Netzanschlusspunkt angeordnet ist, an dem wenigstens eine dezentrale Erzeugungseinheit, insbesondere eine Windenergieanlage oder ein Windpark, in das elektrische Versorgungsnetz einspeist. Dabei ist die Erfassungseinrichtung dazu vorbereitet, wenigstens eine elektrische Größe der Einspeisung aufzunehmen. Die Auswerteeinrichtung ist dann dazu vorbereitet, diese wenigstens eine aufgenommene elektrische Größe mittels einer bzw. der Wavelet-Analyse auszuwerten. Die wenigstens eine elektrische Größe ist dabei ein von der dezentralen Erzeugungseinheit eingespeister Strom, eine von der dezentralen Erzeugungseinheit eingespeiste Leistung, nämlich eine Blindleistung und/oder eine Wirkleistung, oder eine Spannung am Netzanschlusspunkt oder eine dazu proportionale Spannung, bei der die dezentrale Erzeugungseinheit elektrischen Strom in das elektrische Versorgungsnetz einspeist. Damit kann eine solche Erkennungseinrichtung in vorteilhafter Weise bei einer solchen dezentralen Erzeugungseinheit angeordnet und eingesetzt werden. Sie kann auch Teil der dezentralen Erzeugungseinheit sein, insbesondere kann sie Teil einer Steuereinheit der dezentralen Erzeugungseinheit sein, wie beispielsweise Teil eines Parkreglers oder Teil einer Windenergieanlagensteuerung.

Ansonsten ergeben sich die Vorteile und Wirkungen dieser Erkennungseinrichtung an einem Netzanschlusspunkt, an dem die dezentrale Erzeugungseinheit angeordnet ist, aus den vorstehenden Erläuterungen zu entsprechenden Ausführungsformen eines Verfahrens zum Erkennen niederfrequenter Schwingungen, das an einem Netzanschlusspunkt vorgenommen wird, an dem wenigstens eine dezentrale Erzeugungseinheit einspeist.

Vorzugsweise ist eine Erkennungseinrichtung dadurch gekennzeichnet, dass sie ein Verfahren gemäß wenigstens einer vorstehend beschriebenen Ausführungsform verwendet bzw. umsetzt.

Erfindungsgemäß wird auch eine dezentrale Erzeugungseinheit, insbesondere eine Windenergieanlage oder ein Windpark vorgeschlagen. Eine solche dezentrale Erzeugungseinheit ist zum Einspeisen elektrischer Leistung in ein elektrisches Versorgungsnetz an einem Netzanschlusspunkt an dieses elektrische Versorgungsnetz angeschlossen. Die dezentrale Erzeugungseinheit umfasst dabei eine Erkennungseinrichtung zum Erkennen niederfrequenter Schwingungen, insbesondere subsynchroner Resonanzen, in dem elektrischen Versorgungsnetz. Das elektrische Versorgungsnetz weist dabei eine Netzspannung mit einer Netznennfrequenz auf und die zu erkennenden niederfrequenten Schwingungen weisen eine geringere Frequenz als die Netznennfrequenz auf. Die Erkennungseinrichtung umfasst dabei eine Erfassungseinrichtung zum Erfassen wenigstens eines elektrischen Signals des elektrischen Versorgungsnetzes. Außerdem umfasst die Erkennungseinrichtung eine Auswerteeinrichtung zum Auswerten des wenigstens einen erfassten elektrischen Signals. Die Auswerteeinrichtung bedient sich dabei einer Wavelet-Analyse, bei der über eine Korrelationsanalyse des erfassten Signals mit einer vorbestimmten Wavelet-Mutterfunktion ein zeitabhängiges Frequenzbild erstellt wird. Die Auswerteeinrichtung ist dabei so eingerichtet, dass sie auf das Vorliegen einer niederfrequenten Schwingung erkennt, wenn in dem zeitabhängigen Frequenzbild zusätzlich zu einem Grundanteil wenigstens ein weiterer niederfrequenter Frequenzanteil vorhanden ist. Die Erkennungseinrichtung ist dabei vorzugsweise so ausgebildet und/oder arbeitet dabei insbesondere so, wie vorstehend gemäß einer Ausführungsform einer Erkennungseinrichtung erläutert wurde.

Nachfolgend wird die Erfindung anhand von Ausführungsformen unter Bezugnahme auf die begleitenden Figuren beispielhaft näher erläutert.
- Figur 1: zeigt eine Windenergieanlage in einer perspektivischen Darstellung.
- Figur 2: zeigt einen Windpark in einer schematischen Darstellung.
- Figur 3: zeigt in einer schematischen Darstellung eine vereinfachte Struktur zum Erfassen und Weiterverarbeiten niederfrequenter Schwingungen.
- Figur 4: veranschaulicht einen Ausschnitt der Struktur der Figur 3.
- Figur 5: veranschaulicht eine mögliche Signalauswertung eines Elementes der Figur 4.
- Figur 6: veranschaulicht ein mögliches Ergebnis der in Figur 4 veranschaulichten Analyse.

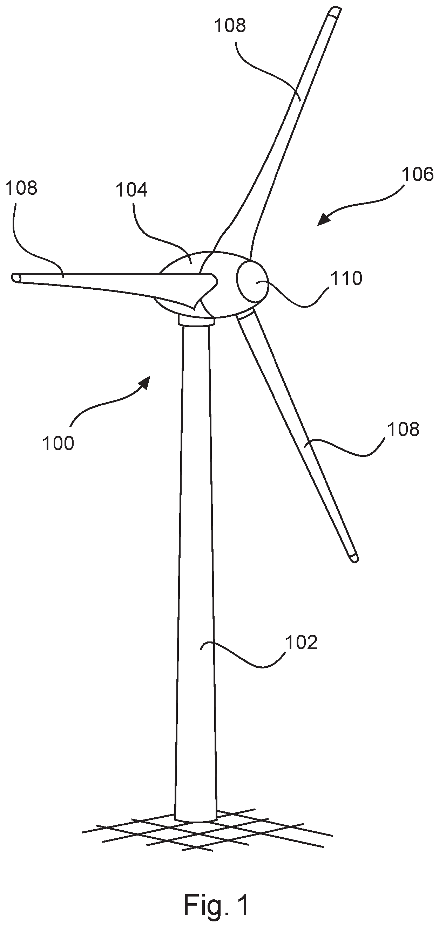

Figur 1 zeigt eine Windenergieanlage 100 mit einem Turm 102 und einer Gondel 104. An der Gondel 104 ist ein Rotor 106 mit drei Rotorblättern 108 und einem Spinner 110 angeordnet. Der Rotor 106 wird im Betrieb durch den Wind in eine Drehbewegung versetzt und treibt dadurch einen Generator in der Gondel 104 an.

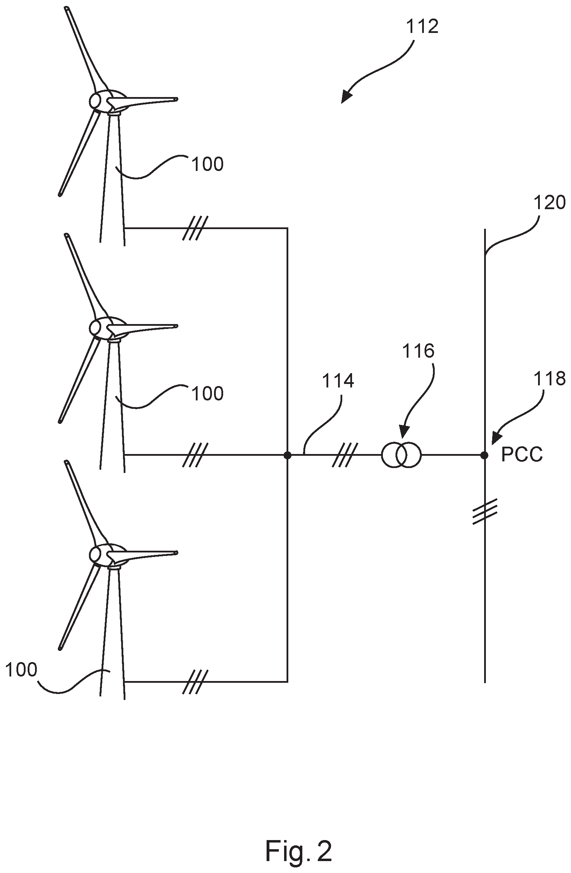

Figur 2 zeigt einen Windpark 112 mit beispielhaft drei Windenergieanlagen 100, die gleich oder verschieden sein können. Die drei Windenergieanlagen 100 stehen somit repräsentativ für im Grunde eine beliebige Anzahl von Windenergieanlagen eines Windparks 112. Die Windenergieanlagen 100 stellen ihre Leistung, nämlich insbesondere den erzeugten Strom über ein elektrisches Parknetz 114 bereit. Dabei werden die jeweils erzeugten Ströme bzw. Leistungen der einzelnen Windenergieanlagen 100 aufaddiert und meist ist ein Transformator 116 vorgesehen, der die Spannung im Park hochtransformiert, um dann an dem Einspeisepunkt 118, der auch allgemein als PCC bezeichnet wird, in das Versorgungsnetz 120 einzuspeisen. Fig. 2 ist nur eine vereinfachte Darstellung eines Windparks 112, die beispielsweise keine Steuerung zeigt, obwohl natürlich eine Steuerung vorhanden ist. Auch kann beispielsweise das Parknetz 114 anders gestaltet sein, indem beispielsweise auch ein Transformator am Ausgang jeder Windenergieanlage 100 vorhanden ist, um nur ein anderes Ausführungsbeispiel zu nennen.

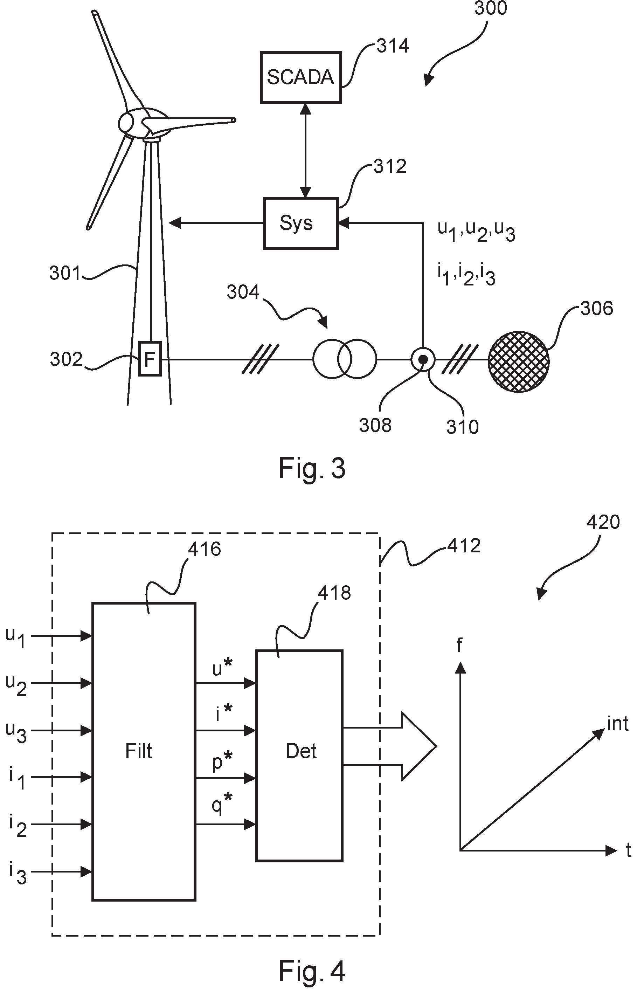

Figur 3 zeigt schematisch eine vereinfachte Struktur als Übersicht einer vorgeschlagenen Analyse niederfrequenter Schwingungen zum Erkennen solcher niederfrequenter Schwingungen. Gemäß dieser Übersichtsstruktur 300 ist eine Windenergieanlage 301 schematisch dargestellt, die beispielsweise mittels eines schematisch dargestellten Frequenzwechselrichters 302 dreiphasig über einen Transformator 304 in ein elektrisches Versorgungsnetz 306 einspeist. Die dabei eingespeisten Ströme i₁, i₂, i₃ und die dabei vorhandenen Spannungen u₁, u₂ und u₃ jeder Phase werden dabei an dem Messpunkt 308 mittels einer schematisch angedeuteten Messeinrichtung 310 erfasst und dem Auswertesystem 312 zugeführt. Der Messpunkt 308 kann auch einen Netzanschlusspunkt des elektrischen Versorgungsnetzes 306 bilden. Die an dem Messpunkt 308 erfassten Spannungen u₁, u₂ und u₃ bilden damit gleichzeitig auch die Spannungen des elektrischen Versorgungsnetzes 306 an diesem Netzanschlusspunkt am Messpunkt 308. In jedem Fall können diese an dem Messpunkt 308 erfassten Spannungen aber Aufschluss über die entsprechenden Spannungen im elektrischen Versorgungsnetz 306 geben.

In dem Auswertesystem 312 kann dann die Auswertung der so erfassten Signale, nämlich Spannungen und Ströme durchgeführt werden. Die Auswertung kann sich dabei auch eines externen Systems bedienen, das hier in dem externen Block 314 als SCADA illustriert ist. Dieses SCADA oder SCADA-System in dem externen Block 314 kann die Analyse zum Erkennen niederfrequenter Schwingungen zumindest durchführen oder unterstützen. Es kommt auch in Betracht, dass dieses SCADA-System gemäß dem externen Block 314 ergänzend eingesetzt wird, um beispielsweise ergänzende Analysen durchzuführen, um beispielsweise die eigentliche Analyse zum Erkennen der niederfrequenten Schwingungen zu verbessern. Durch einen Kommunikationsanschluss zum SCADA-System gemäß Block 314 würde sich das Auswertungsergebnis aus der Ferne übertragen lassen.

Gemäß einer Ausführungsform erfolgt die Analyse zum Erkennen der niederfrequenten Schwingungen in dem Auswertesystem 312 und das ist in Figur 4 veranschaulicht.

Figur 4 zeigt somit das Auswertesystem 312 ebenfalls schematisch aber mit weiteren Details. Die mögliche Kommunikation zu dem externen Block 314 ist in Figur 4 der Einfachheit halber nicht dargestellt.

Das Auswertesystem 312 wird in Figur 4 der Einfachheit halber als Auswertesystem 412 gekennzeichnet. Dort ist gezeigt, dass die sechs Messgrößen u₁, u₂, u₃ sowie i₁, i₂, i₃ Eingangsgrößen in dem Filterblock 416 Bilden. In dem Filterblock 416 kann somit zum einen eine Filterung durchgeführt werden, die beispielsweise hochfrequente Anteile aus den erfassten Signalen herausfiltert. Der Filterblock 416 extrahiert aber auch dabei oder im Anschluss zur Filterung Komponenten aus diesen Messsignalen. Besonders ist vorgesehen, eine repräsentative Spannung u*, einen repräsentativen Strom i*, eine Gesamtwirkleistung p* und eine Gesamtblindleistung q* zu bestimmen. Diese repräsentativen bzw. Gesamtgrößen geben dabei jeweils ein entsprechendes Signal für alle drei Phasen zusammen wieder. Diese vier Größen, die den Ausgang des Filterblocks 416 bilden, werden entsprechend jeweils als Zeitsignal in dem Determinierungsblock 418 eingegeben. In dem Determinierungsblock 418 wird dann die Determinierung, also Bestimmung der niederfrequenten Schwingungen durchgeführt, zumindest wird ein erster wichtiger Schritt davon durchgeführt. In dem Determinierungsblock 418 erfolgt nämlich die Auswertung des jeweiligen elektrischen Signals, also u*, i*, p* bzw. q* mittels einer Wavelet-Analyse. Das erfolgt so, dass ein zeitabhängiges Frequenzbild über eine Korrelationsanalyse des jeweiligen erfassten Signals mit einer vorbestimmten Wavelet-Mutterfunktion erstellt wird. Die genannten Signale, die der Filterblock 416 ausgibt und in den Determinierungsblock 418 eingibt, also die Spannung u*, der Strom i*, die Leistung p* bzw. die Blindleistung q* bilden somit jeweils ein erfasstes Signal.

Eine solche Wavelet-Analyse kann dann mit jedem der vier Signale durchgeführt werden, die von dem Filterblock 416 dem Determinierungsblock 418 übergeben werden. Die resultierenden vier Ergebnisse können dann weiterverarbeitet werden und im einfachsten Fall wird nur das aussagekräftigste Ergebnis weiterverwendet.

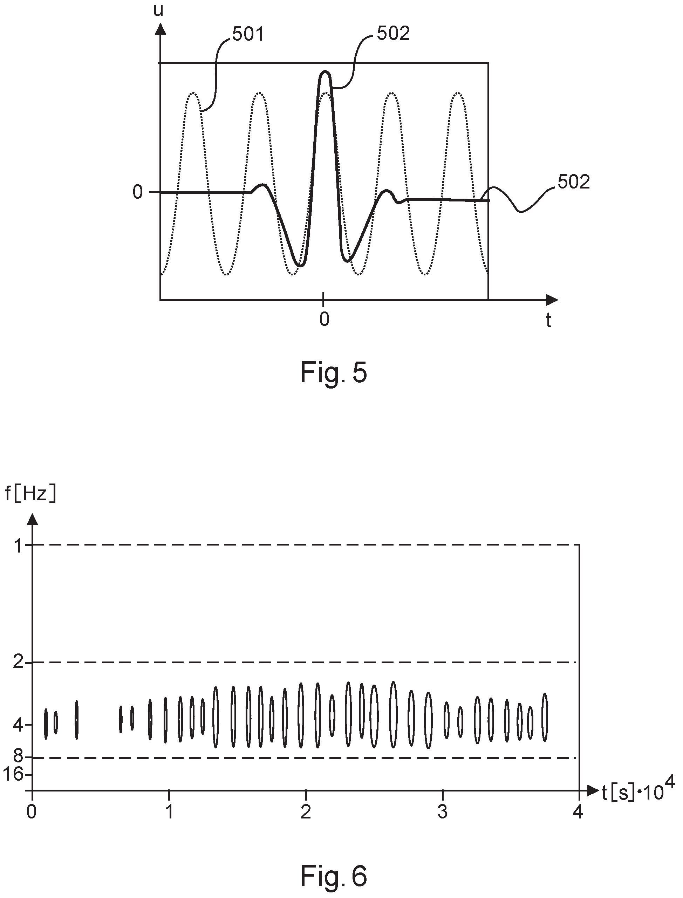

Jedenfalls ist das Ergebnis der Analyse im Determinierungsblock 418 ein zeitabhängiges Frequenzbild 420, das in der Figur 4 nur schematisch angedeutet ist. Dort ist nämlich nur über ein dreidimensionales Koordinatenkreuz angedeutet, dass das Ergebnis eine zeitabhängige Frequenz zeigt, wobei zusätzlich die Intensität betrachtet werden kann. Das soll durch die drei Achsenbeschriftungen "t", "f" und "int" angedeutet werden. Eine weitere Darstellung zu diesem Ergebnis, das hier dieses zeitabhängige Frequenzbild 420 andeutet, wird noch im Zusammenhang mit der Figur 6 erläutert.

Figur 5 zeigt schematisch eine mögliche Auswertung, die in dem Determinierungsblock 418 der Figur 4 ausgeführt werden kann. In diesem Beispiel der Figur 5 erfolgt eine Wavelet-Analyse mittels einer Korrelationsanalyse, bei der das erfasste Signal 501 mit einer Wavelet-Mutterfunktion 502 korreliert wird. Die Wavelet-Mutterfunktion 502 ist hierbei über die Zeit symmetrisch und ihr Maximalwert bildet dabei ihren zeitlichen Mittelpunkt und der wird bei der Analyse auf den zeitlichen Nullpunkt gelegt. Zu diesem zeitlichen Nullpunkt führt aufgrund der hohen Amplitude der Wavelet-Mutterfunktion eine hohe Korrelation auch zu einer hohen Intensität zu dem Zeitpunkt. Zu Zeiten deutlich vor oder deutlich nach diesem zugrunde gelegten zeitlichen Nullpunkt ist die Wavelet-Mutterfunktion 502 im Wesentlichen null, so dass dort keine Korrelation mehr auftreten kann und entsprechend auch keine Intensität.

Eine solche in Figur 5 veranschaulichte Analyse wird dabei kontinuierlich oder zumindest quasi kontinuierlich ständig wiederholt, so dass sich ein zeitabhängiges Frequenzbild mit Intensitäten ergibt.

Das erfasste Signal 501 kann somit das sinusförmige Spannungssignal sein, das repräsentativ für die drei Phasenspannungen u₁, u₂ und u₃ steht. Dieses sinusförmige Signal ist dem Grunde nach natürlich bekannt und entsprechend kann darauf die Wavelet-Mutterfunktion 502 angepasst werden. Die zu erfassenden niederfrequenten Schwingungen sind insoweit Überlagerungen zu der ideal sinusförmigen Funktion und diese Überlagerungen sollen durch diese Wavelet-Analyse, also auch durch die Wahl der Wavelet-Mutterfunktion 502 extrahiert werden oder zumindest stärker hervortreten.

Figur 6 veranschaulicht ein zeitabhängiges Frequenzbild, das somit dem Ergebnis des Determinierungsblocks 418 entspricht, also dem in Figur 4 angedeuteten zeitabhängigen Frequenzbild, und das auch das Ergebnis einer im Zusammenhang mit Figur 5 erläuterten stetig wiederholten Analyse ist.

In Figur 6 zeigt das Diagramm über einen Zeitbereich von 0 bis 40000 s einen Frequenzbereich, der logarithmisch aufgetragen ist. Die Frequenz ist hier etwa von 30 Hz bis 1 Hz aufgetragen. Zur Verbesserung der Darstellung sind gestrichelt Frequenzlinien für 1 Hz, 2 Hz und 8 Hz eingezeichnet.

Das Ergebnis der Wavelet-Analyse ist, zu den jeweiligen Zeiten und den jeweiligen Frequenzen jeweils aufgetretene Intensitäten, zu zeigen. Üblicherweise bedient sich die Darstellung dabei einer Farbskala, bei der beispielsweise die Farbskala von dunkelblau über grün und orange bis gelb reicht, wobei dunkelblau eine geringe und gelb eine hohe Intensität darstellen kann. In Figur 6 wurde der Versuch unternommen, eine solche Intensität durch entsprechend stark ausgeprägte Bereiche zu veranschaulichen, um dadurch ohne Farbskala auszukommen. Demnach gibt es eine hohe Intensität etwa im Bereich von 3 bis 6 Hz. Es ist aber auch zu erkennen, dass diese Intensität besonders im Bereich zwischen 2 und 3, also zwischen 20000 und 30000 s ausgeprägt ist. Es ist somit zu erkennen, dass in den dort zu Grunde liegenden drei Stunden eine besonders starke Schwingung im Bereich von 3 bis 6 Hz aufgetreten ist. Im Bereich von 0 bis 1, also 0 bis 10000 s, tritt keine nennenswerte Intensität in diesem Frequenzbereich auf. Entsprechend kann daraus ein Schluss über diese niederfrequente Schwingung, oder niederfrequenten Schwingungen, abgeleitet werden.

Zum Durchführen einer Steuerung, die einer niederfrequenten Schwingung entgegenwirkt, kommt aber auch in Betracht, einen deutlich kleineren Zeitraum zu betrachten. Dazu kann die beschriebene Analyse für einen entsprechend kürzeren Zeitraum ausgeführt werden. Die Wavelet-Mutterfunktion kann dafür angepasst werden, kann aber ggf. auch unverändert weiterverwendet werden. Jedenfalls insoweit die Wavelet-Mutterfunktion auf den zu erwartenden Frequenzbereich abgestimmt ist, in dem die niederfrequenten Schwingungen erwartet werden, ist eine Anpassung an einen kürzeren Erfassungszeitraum nicht unbedingt erforderlich.

Durch die vorgeschlagene Erfindung kann besonders eine Einheit bereitgestellt werden, die eine Energiesystemstabilität beobachten und einschätzen kann. Dabei wurde erkannt, dass Schwingungen im Energiesystem, besonders im elektrischen Versorgungsnetz, die auch als Power System Oscillations (PSO) oder Energiesystemschwingungen bezeichnet werden, ein guter Indikator zur Instabilität von Energiesystemen sein können. Weiterhin kann die Beobachtung und Identifizierung von Power System Oscillations ein wichtiger Bestandsteil zukünftiger Netzdienstleistungen werden, die beispielsweise auf die Dämpfung solcher Oszillationen zielen.

Die vorliegende Erfindung ist somit auf die Identifikation von Power System Oscillations gerichtet. Die Beobachtung von Power System Oscillations kann nicht nur für ein Warnungssystem für den Betrieb von Windparks hilfreich sein, sondern diese Information kann auch benutzt werden, um geeignete Dämpfungssignale durch einen Windpark zur Bedämpfung der Power System Oscillations zu generieren und einzuspeisen.

Anders als bei anderen bekannten Ansätzen zur Identifikation von niederfrequenten Schwingungen wird hier ein Wavelet-basiertes Verfahren verwendet. Dazu wurde erkannt, dass das Nutzen von Wavelets die Detektion von nichtstationären Phänomenen mit Lokalitätseigenschaften sowohl im Zeit- als auch im Frequenzbereich ermöglicht.

Die vorgeschlagene Lösung eignet sich grundsätzlich für an Verbundnetze angeschlossene Einheiten, wie Windenergieanlagen oder Windparks, ist aber nicht darauf beschränkt. Die vorgeschlagene Lösung lässt sich auch auf Verbrauchereinheiten anwenden.

Das vorgeschlagene Verfahren betrifft somit eine Online-Detektion von Power System Oscillations. Es eignet sich für Erzeugungs- als auch für Verbraucheranlagen.

Das Verfahren basiert auf einer Online-Analyse von transienten Messdaten bspw. von einem Netzanschlusspunkt.

Der Erfindung liegt somit besonders der Gedanke zugrunde, die Detektion von Power System Oscillations auf Basis einer transienten Messung der gemessenen Netzanschlussspannung und Leistungen vorzunehmen. Eine Abtastrate von vorzugsweise mindestens 500 Hz für niederfrequente Schwingungen im Frequenzbereich von 0<f< fünffache Nennfrequenz wird für alle vorhandenen Messkanäle vorgeschlagen.

Das vorgeschlagene, auf Wavelet basierte Verfahren kann benutzt werden, um sowohl periodische als auch aperiodische Frequenzen im angegebenen Frequenzbereich zu detektieren, was abhängig von der Dauer des zu analysierenden Zeitfensters sein kann, weil die vorgeschlagenen Wavelets möglichst über die Lokalitätseigenschaft sowohl im Frequenz- als auch im Zeitbereich verfügen sollten.

Die Wahl der Wavelet-Mutterfunktion, die auch als Mutter-Wavelet bezeichnet werden kann, als auch des zu analysierenden Zeitfensters können eine Rolle spielen.

Ein solches System oder Verfahren für die Detektion von Power System Oscillations kann sowohl auf Windenergieanlagen- als auch auf Windparkebene implementiert werden, was hiermit vorgeschlagen wird.

Das vorgeschlagene Verfahren eignet sich auch dazu, automatisiert zu werden. Ein vorgeschlagenes Kriterium ist, dass das Integral der Mutter-Wavelets, vorzugsweise aller Mutter-Wavelets, null sein sollte. Das wird zu dieser Erfindung besonders vorgeschlagen und ist nicht generell für ein Wavelet-Verfahren selbstverständlich, denn Mutter-Wavelets können in anderen Anwendungen auch anders aussehen.

## Patentansprüche

1. Verfahren zum Erkennen niederfrequenter Schwingungen, insbesondere subsynchroner Resonanzen in einem elektrischen Versorgungsnetz (306), wobei das elektrische Versorgungsnetz (306) eine Netzspannung mit einer Netznennfrequenz aufweist, umfassend die Schritte
- Erfassen wenigstens eines elektrischen Signals des elektrischen Versorgungsnetzes (306) und
- Auswerten des elektrischen Signals mittels einer Wavelet-Analyse, bei der über eine Korrelationsanalyse des erfassten Signals mit einer vorbestimmten Wavelet-Mutterfunktion (502) ein zeitabhängiges Frequenzbild (420) erstellt wird,
- wobei vom Vorliegen einer niederfrequenten Schwingung ausgegangen wird, wenn
- in dem zeitabhängigen Frequenzbild (420) zusätzlich zu einem Grundanteil wenigstens ein weiterer niederfrequenter Frequenzanteil vorhanden ist,
**dadurch gekennzeichnet, dass**
- das Verfahren an einem Netzanschlusspunkt vorgenommen wird, an dem wenigstens eine dezentrale Erzeugungseinheit, insbesondere eine Windenergieanlage (100, 301) oder ein Windpark (112), in das elektrische Versorgungsnetz (306) einspeist, wobei
- zur Erkennung der niederfrequenten Schwingungen wenigstens eine elektrische Größe der Einspeisung aufgenommen und mittels der Wavelet-Analyse ausgewertet wird.

2. Verfahren nach Anspruch 1,
**dadurch gekennzeichnet, dass**
zusätzlich geprüft wird, ob der wenigstens eine weitere niederfrequente Frequenzanteil schwankt, insbesondere aperiodisch schwankt.

3. Verfahren nach Anspruch 1 oder 2,
**dadurch gekennzeichnet, dass**
ein zeitlicher Verlauf einer Amplitude des wenigstens einen weiteren Frequenzanteils erfasst wird.

4. Verfahren nach einem der vorstehenden Ansprüche,
**dadurch gekennzeichnet, dass**
für das Auswerten des elektrischen Signals ein Prüffrequenzbereich zu Grunde gelegt wird und
der Prüffrequenzbereich von einer Frequenzuntergrenze bis zu einer Frequenzobergrenze reicht und
- die Frequenzuntergrenze in einem Bereich von 0,1Hz bis 2 Hz liegt, insbesondere 1Hz aufweist, und
- die Frequenzobergrenze in einem Bereich von einem Wert der Nennfrequenz bis zu einem fünffachen Wert der Nennfrequenz liegt, insbesondere den Wert der Nennfrequenz aufweist.

5. Verfahren nach einem der vorstehenden Ansprüche,
**dadurch gekennzeichnet, dass**
- als elektrisches Signal eine dreiphasige Spannung, insbesondere die Netzspannung, erfasst wird und
- die so erfasste dreiphasige Spannung gefiltert oder transformiert wird, insbesondere in eine d/q-Darstellung transformiert wird, und die Wavelet-Analyse auf das gefilterte bzw. transformierte Signal angewendet wird.

6. Verfahren nach einem der vorstehenden Ansprüche,
**dadurch gekennzeichnet, dass**
die Wavelet-Mutterfunktion (502) wenigstens eine Eigenschaft aufweist aus der Liste aufweisend die folgenden Eigenschaften:
I) die Wavelet-Mutterfunktion (502) ist dazu vorbereitet, skalierbar zu sein, insbesondere nach der Zeit oder der Frequenz,
II) die Wavelet-Mutterfunktion (502) ist dazu vorbereitet, zeitlich verschiebbar zu sein,
III) die Wavelet-Mutterfunktion (502) weist Lokalität sowohl im Frequenzbereich als auch im Zeitbereich auf,
IV) die Wavelet-Mutterfunktion (502) weist im Zeitbereich ein Integral auf, das 0 ist,
V) als Wavelet-Mutterfunktion (502) wird eine Wavelet-Funktion aus der Liste verwendet, aufweisend:
a. ein Morlet-Wavelet,
b. ein Daubechies D20-Wavelet
c. einen Mexikanischen Hut.

7. Verfahren nach einem der vorstehenden Ansprüche,
**dadurch gekennzeichnet, dass**
- eine Wavelet-Mutterfunktion (502) in Abhängigkeit eines Auswahlkriteriums
- aus mehreren vorbestimmten Wavelet-Funktionen ausgewählt wird und/oder
- parametriert wird, wobei optional
- das Auswahlkriterium wenigstens einen Erwartungswert des elektrischen Signals aufweist.

8. Verfahren nach einem der vorstehenden Ansprüche,
**dadurch gekennzeichnet, dass**
- die wenigstens eine elektrische Größe jeweils ausgewählt ist aus der Liste aufweisend:
- einen eingespeisten Strom,
- eine eingespeiste Blindleistung,
- eine eingespeiste Wirkleistung und
- eine Spannung am Netzanschlusspunkt oder eine dazu proportionale Spannung, bei der die dezentrale Erzeugungseinheit elektrischen Strom in das elektrische Versorgungsnetz (306) einspeist.

9. Verfahren nach einem der vorstehenden Ansprüche,
**dadurch gekennzeichnet, dass**
- die erkannte niederfrequente Schwingung als Netzschwingung betrachtet wird,
- eine Windenergieanlage vorgesehen ist, die einen Rotor mit Rotorblättern, einen Generator und einen Wechselrichter zum Einspeisen elektrischer Leistung in das elektrische Versorgungsnetz aufweist, und
- zusätzlich erfasst wird, ob die Windenergieanlage an der Netzschwingung teilnimmt, wobei
- mittels einer Wavelet-Analyse eine niederfrequente Schwingung der Windenergieanlage als Anlagenschwingung erfasst wird, insbesondere
- an einer Zwischenkreisspannung an einem Gleichspannungszwischenkreis des Wechselrichters,
- überprüft wird, ob die Netzschwingung und die Anlagenschwingung korrelieren, und
- darauf erkannt wird, dass die Windenergieanlage an der Netzschwingung teilnimmt, wenn die Netzschwingung und die Anlagenschwingung korrelieren.

10. Verfahren nach Anspruch 9,
**dadurch gekennzeichnet, dass**
- wenn darauf erkannt wurde, dass die Windenergieanlage an der Netzschwingung teilnimmt,
- die Anlagenschwingung darauf überprüft wird, ob sie eine vorgegebene Schwingungsamplitude übersteigt und,
- Dämpfungsmaßnahmen eingeleitet werden, wenn die Anlagenschwingung die vorgegebene Schwingungsamplitude übersteigt, wobei
- die Dämpfungsmaßnahme wenigstens eine Maßnahme umfasst aus der Liste aufweisend:
- Erhöhung eines Dämpfungsanteils einer Regelung des Generators, insbesondere eines Statorstroms des Generators,
- Verwenden einer Pitchregelung zum Einstellen eines Blattwinkels der Rotorblätter, wobei ein Dämpfungsanteil erhöht oder eingestellt wird,
- Erhöhung eines Dämpfungsanteils einer Einspeiseregelung zum Steuern des Wechselrichters zum Einspeisen in das elektrische Versorgungsnetz,
- Verschiebung eines Arbeitspunktes der Einspeisung, insbesondere durch eine Reduzierung der eingespeisten Leistung, und
- Aktivierung einer Stromregelung des Wechselrichters zur Steuerung eines Einspeisestroms, wobei ein Dämpfungsanteil erhöht oder eingestellt wird.

11. Verfahren nach einem der vorstehenden Ansprüche,
**dadurch gekennzeichnet, dass**
- das wenigstens eine elektrische Signal mittels einer mit einer Abtastfrequenz abtastenden Messung erfasst wird, um jeweils ein Abtastsignal des elektrischen Signals zu erhalten, wobei
- die Abtastfrequenz um ein Vielfaches über dem Grundanteil liegt, insbesondere wenigstens einen zehnfachen Wert des Grundanteils aufweist, um einen transienten Charakter des elektrischen Signals zu erfassen,
- zum Auswerten des elektrischen Signals jeweils das Abtastsignal mittels der Wavelet-Analyse ausgewertet wird, insbesondere ohne eine den transienten Charakter des elektrischen Signals verändernden Filterung.

12. Erkennungseinrichtung zum Erkennen niederfrequenter Schwingungen, insbesondere subsynchroner Resonanzen in einem elektrischen Versorgungsnetz (306), wobei das elektrische Versorgungsnetz (306) eine Netzspannung mit einer Netznennfrequenz aufweist, umfassend
- eine Erfassungseinrichtung zum Erfassen wenigstens eines elektrischen Signals des elektrischen Versorgungsnetzes (306) und
- eine Auswerteeinrichtung zum Auswerten des elektrischen Signals mittels einer Wavelet-Analyse, bei der über eine Korrelationsanalyse des erfassten Signals mit einer vorbestimmten Wavelet-Mutterfunktion (502) ein zeitabhängiges Frequenzbild (420) erstellt wird,
- wobei die Auswerteeinrichtung so eingerichtet ist, dass sie auf das Vorliegen einer niederfrequenten Schwingung erkennt, wenn
- in dem zeitabhängigen Frequenzbild (420) zusätzlich zu einem Grundanteil wenigstens ein weiterer niederfrequenter Frequenzanteil vorhanden ist,
**dadurch gekennzeichnet, dass**
- das Verfahren an einem Netzanschlusspunkt vorgenommen wird, an dem wenigstens eine dezentrale Erzeugungseinheit, insbesondere eine Windenergieanlage (100, 301) oder ein Windpark (112), in das elektrische Versorgungsnetz (306) einspeist, wobei
- zur Erkennung der niederfrequenten Schwingungen wenigstens eine elektrische Größe der Einspeisung aufgenommen und mittels der Wavelet-Analyse ausgewertet wird.

13. Erkennungseinrichtung nach Anspruch 12,
**dadurch gekennzeichnet, dass**
- die Erkennungseinrichtung an einem Netzanschlusspunkt angeordnet ist, an dem wenigstens eine dezentrale Erzeugungseinheit, insbesondere eine Windenergieanlage (100, 301) oder ein Windpark (112), in das elektrische Versorgungsnetz (306) einspeist, wobei
- die Erfassungseinrichtung vorbereitet ist, wenigstens eine elektrische Größe der Einspeisung aufzunehmen und wobei
- die Auswerteeinrichtung dazu vorbereitet ist, die wenigstens eine aufgenommene elektrische Größe mittels einer bzw. der Wavelet-Analyse auszuwerten, wobei
- die wenigstens eine elektrische Größe jeweils ausgewählt ist aus der Liste aufweisend:
- einen eingespeisten Strom,
- eine eingespeiste Blindleistung,
- eine eingespeiste Wirkleistung und
- eine Spannung am Netzanschlusspunkt oder eine dazu proportionale Spannung, bei der die dezentrale Erzeugungseinheit elektrischen Strom in das elektrische Versorgungsnetz (306) einspeist.

14. Erkennungseinrichtung nach Anspruch 12 oder 13,
**dadurch gekennzeichnet, dass**
sie ein Verfahren gemäß einem der Ansprüche 1 bis 11 verwendet.

15. Dezentrale Erzeugungseinheit, insbesondere Windenergieanlage oder Windpark (112), wobei die dezentrale Erzeugungseinheit zum Einspeisen elektrischer Leistung in ein elektrisches Versorgungsnetz (306) an einem Netzanschlusspunkt an das elektrische Versorgungsnetz (306) angeschlossen ist, und die dezentrale Erzeugungseinheit umfasst
- eine Erkennungseinrichtung zum Erkennen niederfrequenter Schwingungen, insbesondere subsynchroner Resonanzen, in dem elektrischen Versorgungsnetz (306), wobei das elektrische Versorgungsnetz (306) eine Netzspannung mit einer Netznennfrequenz aufweist und die zu erkennenden niederfrequenten Schwingungen eine geringere Frequenz als die Netznennfrequenz aufweisen, und die Erkennungseinrichtung umfasst
- eine Erfassungseinrichtung zum Erfassen wenigstens eines elektrischen Signals des elektrischen Versorgungsnetzes (306) und
- eine Auswerteeinrichtung zum Auswerten des erfassten elektrischen Signals mittels einer Wavelet-Analyse, bei der über eine Korrelationsanalyse des erfassten elektrischen Signals mit einer vorbestimmten Wavelet-Mutterfunktion (502) ein zeitabhängiges Frequenzbild (420) erstellt wird,
- wobei die Auswerteeinrichtung so eingerichtet ist, dass sie auf das Vorliegen einer niederfrequenten Schwingung erkennt, wenn
- in dem zeitabhängigen Frequenzbild (420) zusätzlich zu einem Grundanteil wenigstens ein weiterer niederfrequenter Frequenzanteil vorhanden ist,
**dadurch gekennzeichnet, dass**
- das Verfahren an einem Netzanschlusspunkt vorgenommen wird, an dem wenigstens eine dezentrale Erzeugungseinheit, insbesondere eine Windenergieanlage (100, 301) oder ein Windpark (112), in das elektrische Versorgungsnetz (306) einspeist, wobei
- zur Erkennung der niederfrequenten Schwingungen wenigstens eine elektrische Größe der Einspeisung aufgenommen und mittels der Wavelet-Analyse ausgewertet wird.

16. Dezentrale Erzeugungseinheit nach Anspruch 15,
**dadurch gekennzeichnet, dass**
als die Erkennungseinrichtung eine Erkennungseinrichtung nach einem der Ansprüche 12 bis 14 verwendet wird.
